# EUROPEAN PATENT SPECIFICATION

(11) **EP 1 338 088 B1**
(45) Date of publication and mention of the grant of the patent: **28.04.2004**
(21) Application number: 01982587.6
(22) Date of filing: 01.11.2001
(51) Int. Cl.: H03G 3/00

(54) **SIGNAL LEVEL CONTROL**
SIGNALPEGELREGELUNG
REGULATION DE L'INTENSITE DE SIGNAUX

(30) Priority: 28.11.2000 GB 0029006
(43) Date of publication of application: 27.08.2003
(73) Proprietor: Ubinetics Limited, Melbourn, Hertfordshire SG8 6DP (GB)
(72) Inventor: THURSTON, Andy, Cambridge CB3 0QG (GB); LUCAS, Jonathan, Melbourn, Hertfordshire SG8 6JA (GB)
(74) Representative: Gillard, Matthew Paul
(86) International application number: PCT/GB2001/004854
(87) International publication number: WO 2002/045259

(56) References cited:
- EP-A- 0 413 311
- US-A- 5 161 170
- US-A- 5 734 974

## Description

This invention relates to methods and apparatus of controlling the gain applied to a received signal, in particular to a wireless signal received by a telecommunications device.

A telecommunications receiver may be designed to operate optimally with received signals of a predetermined amplitude. Therefore, telecommunication receivers may be provided with an amplifying arrangement which has a gain factor G appropriate to endow the received signals with an amplitude close to a predetermined optimum.

In a mobile telecommunications system, the strength of a received signal will vary according to changes in the separation of the receiver and the transmitter. Thus, a fixed-gain amplifying arrangement is often not useful for shifting received signals to the predetermined optimum amplitude.

It is known to provide a telecommunications receiver with an amplifying arrangement having an automatic gain control (AGC) feature. The amplitude of the amplified signal produced by the amplifying arrangement is compared with a threshold value. The gain factor of the amplifying arrangement is then altered by an amount dependent in magnitude and sign upon, respectively, the magnitude and sign of the difference between the measured amplitude and the threshold. The document US-A-5 734 974 discloses an AGC with improved stability obtained by performing an integration operation on the relevant amplitude signal.

The object of the invention is the provision of improved gain control.

According to a first aspect, the invention provides a method of controlling the gain applied to a received signal, comprising determining a parameter comprising the difference between maximum and minimum levels of the received signal over a period of time and adjusting the gain each time the parameter indicates that the amplitude is outside an amplitude range defined between an upper and a lower amplitude threshold.

According to a second aspect, the invention provides apparatus for controlling the gain applied to a received signal, comprising means for determining a parameter comprising the difference between maximum and minimum levels of the received signal over a period of time and means for adjusting the gain each time the parameter indicates that the amplitude is outside an amplitude range defined between an upper and a lower amplitude threshold.

By comparing the amplitude with a range, it is possible to avoid rapid, and possibly oscillatory, variation of the gain due to minor changes in the measured amplitude. Thus, the processing burden is reduced.

In one embodiment, gain variation is achieved by adjusting a gain parameter by a predetermined or fixed amount each time a variation is required. This advantageously decreases the processing burden since the adjustment process need only indicate the direction of a desired change, and not its magnitude.

In a preferred embodiment, the parameter of the gain which is adjusted is the logarithm of the gain. This provides for fine control of gain value, especially where a system of incrementing and decrementing the logarithm by a fixed amount is used.

The invention may be employed in a telecommunications receiver such a base station or a mobile unit in a mobile communications system.

By way of example only, an embodiment of the invention will now be described with reference to the accompanying drawings in which:
Figure 1 illustrates schematically a mobile telephone;
Figure 2 is a plot, on a logarithmic scale, of the amplitude of a received signal versus time; and
Figure 3 is a plot, on a logarithmic scale, of the same signal after amplification in the telephone of Figure 1.

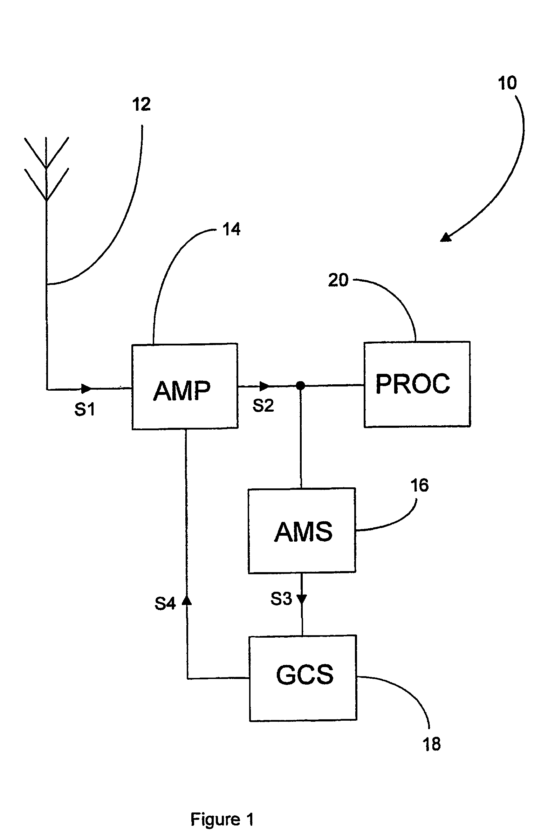

As shown in Figure 1, mobile telephone 10 comprises an antenna 12, an amplifier 14, amplitude measurement section (AMS) 16, gain control section (GCS) 18 and subsequent processing circuitry 20.

The telephone 10 receives a signal S₁ through the antenna 12. Amplifier 14 amplifies S₁ into signal S₂, where S₂ = GS₁, G being the gain of the amplifier 14. The amplified signal S₂ is supplied to digital processing circuitry 20 for subsequent processing to provide, for example, audible signals to the user of the telephone 10.

The gain G of amplifier 14 is set by a gain control signal S₄ from GCS 18. The determination of signal S₄ will now be described.

The AMS 16 measures the amplitude of the received signal over a period of time. The AMS 16 records the maximum and minimum values of signal S₂ encountered during the interval. The minimum value is subtracted from the maximum value to produce an amplitude value for the interval which is less susceptible to offset errors. The amplitude value is transmitted as signal S₃ to the GCS 18 which utilises S₃ to make decisions about changing the gain of amplifier 14.

In general terms, the GCS compares the amplitude value with an upper and a lower threshold. The GCS instructs the gain to be increased if the amplitude falls below the lower threshold (falling below the upper threshold has no effect) and also instructs the gain to be decreased if the amplitude exceeds the higher threshold (exceeding the lower threshold has no effect).

The interval over which the level of signal S₂ is monitored by AMS 16 is then repeated and successive amplitude values are sent to GCS 18 which makes an ongoing series of adjustments to the logarithm of the gain of amplifier 14. It will be appreciated that the gain has overall maximum and minimum values (due to the design of amplifier 14) which cannot be traversed. Upon one of these limits being reached, attempts by the GCS 18 to traverse the limit will be ineffectual and, in this sense, the gain control process is temporarily disabled.

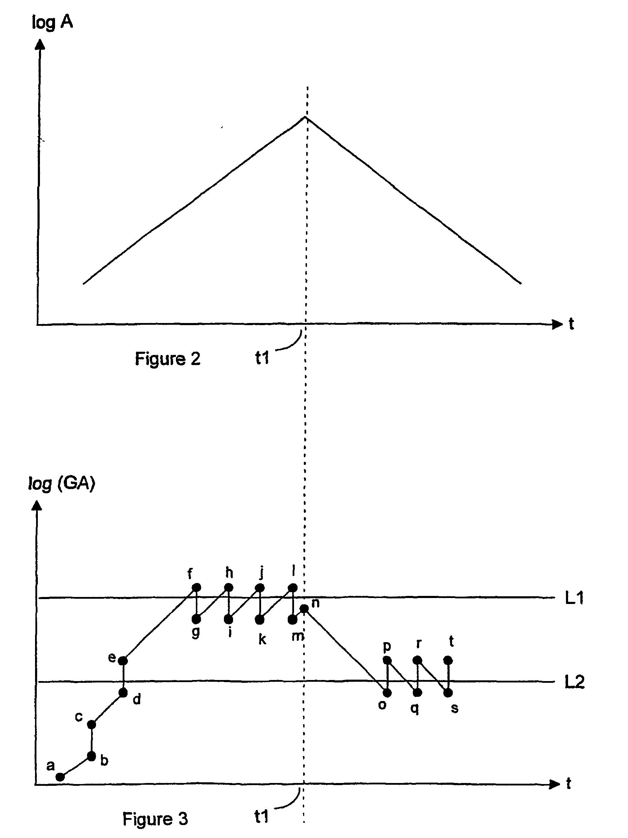

Consider the case where S₁ has the form shown in Figure 2, i.e. the signal amplitude increases until time t1 and decreases thereafter. The corresponding form of S₂ is shown in Figure 3, whose content will now be discussed by reference to Figures 1 and 2. In Figure 3, the signal S₂ is divided into a series of events, a-t. Between a and b, the AMS 16 determines an amplitude value which is supplied to the GSC 18 as S₃. The GCS 18 determines that the amplitude value falls below a lower threshold L2 and operates to increase the gain of amplifier 14. A signal S₄ indicating that the gain is to be increased is sent by the GCS to the amplifier 14. The amplifier 14 responds to S₄ by incrementing the logarithm of the gain by a fixed amount, causing S₂ (=GS₁) to step from b to c.

The AMS 14 then goes through another sampling interval from c to d, sending, at the end of that interval, a new signal S₃ to the GCS 18. The GCS 18 again determines that the new amplitude value falls below the lower threshold L2 and sends an increment command as signal S₄. The amplifier 14 responds to the increment command by incrementing the logarithm of the gain by the same amount as before.

The step to point e raises the amplitude above the lower threshold L2. Therefore, in subsequent intervals GCS 13 receives amplitude values (in signal S₃) which lie between the lower threshold L2 and the upper threshold L1. During this period the increase in S₂ is due to the increasing trend in S₁ only (Figure 3 does not accurately represent the gradient of S₁).

Some time later, at point f, S₂ exceeds the upper threshold L1 and this fact is determined by the GCS 18 using the signal S₃ representative of the amplitude of S₂ over the last sampling interval of the AMS 16. Accordingly, the GCS 18 sends a decrement command as signal S₄ to the amplifier 14. In response, the amplifier 14 decrements the logarithm of the gain by a fixed amount. causing S₂ to step down to point g.

During the next sampling interval of the AMS 14, the amplitude of signal S₂ rises to point h, above the upper threshold L1. The GCS 18 then instructs the amplifier to reduce the logarithm gain by the same amount, bringing S₂ down to point i. This process of decrementing the logarithm of the gain successively continues until point n, which corresponds to time t1, at which the gradient of S₁ becomes a negative constant.

At some later time, the signal S₂ reaches point o, where the GCS 18 determines that the amplitude of S₂ falls below the lower threshold L2 and instructs the amplifier 14 to increment the logarithm of the gain, stepping the signal to point p. Since the signal S₃ is now steadily decreasing in amplitude, it repeatedly falls below the lower threshold L2 and, at points q and s, the logarithm of the gain is stepped up above the threshold L2 to points r and t, respectively.

By applying increments and decrements of the same magnitude to the logarithm of the gain of amplifier 14, the control system is made relatively simple. This scheme means that reductions in the gain follow a geometric series, and the scheme is less coarse than simply applying decrements to the linear gain.

The spacing of the thresholds L1 and L2 may be adjusted as desired. There is a trade-off in the selection of this spacing. A relatively small spacing gives tighter control of the level of signal S₂ but requires more frequent changes in the gain G. With a relatively small spacing there is a reduced probability of numerical overflow in the analogue to digital conversion of signal S₂, but increased switching activity with resulting transient behaviour appearing in signal S₂. With a relatively large spacing between the thresholds L1 and L2, there is a reduction in switching activity with a reduction in the appearance of transients, but an increased probability of numerical overflow in the digital to analogue conversion of S₂ and in the elements of processing circuitry 20.

It will be appreciated that although the invention has been described in the context of controlling the gain applied to a signal (S₁) received in receiver 10, the control mechanism has general applicability to any signal undergoing amplification.

## Claims

1. A method of controlling the gain applied to a received signal, comprising determining a parameter comprising the difference between maximum and minimum levels of the received signal over a period of time and adjusting the gain each time the parameter indicates that the amplitude is outside an amplitude range defined between an upper and a lower amplitude threshold.

2. A method according to claim 1, wherein adjusting the gain comprises adjusting the logarithm of the gain.

3. A method according to claim 2, wherein adjusting the logarithm of the gain comprises incrementing or decrementing the logarithm of the gain by a predetermined amount.

4. A method according to any one of claims 1 to 3, wherein adjusting the gain comprises reducing the gain if the amplitude exceeds the upper threshold, and increasing the gain if the amplitude falls below the lower threshold.

5. A method of modulating a received signal, comprising applying a gain to the received signal and adjusting the gain using the method of any preceding claim.

6. Apparatus for controlling the gain applied to a received signal (51), comprising means (16), determining a parameter comprising the difference between maximum and minimum levels of the received signal over a period of time and means (18) for adjusting the gain each time the parameter indicates that the amplitude is outside an amplitude range defined between an upper and a lower amplitude threshold.

7. Apparatus according to claim 6, wherein the adjusting means (18) comprises means for adjusting the logarithm of the gain.

8. Apparatus according to claim 7, wherein the means for adjusting the logarithm of the gain is arranged to increment or decrement the logarithm of the gain by a predetermined amount.

9. Apparatus according to any one of claims 6 to 8, wherein the adjustment means comprises means for decreasing the gain if the amplitude exceeds the upper threshold and for increasing the gain if the amplitude falls below the lower threshold.

10. Apparatus for modulating a received signal comprising means for applying a gain to the received signal and apparatus according to any one of claims 6 to 9 for varying the gain.

11. A program for carrying out the method of any one of claims 1 to 5.

## Patentansprüche

1. Verfahren zur Regelung des Verstärkungsgrades eines empfangenen Signals. bei dem ein Parameter bestimmt wird, der die Differenz zwischen dem maximalen und dem minimalen Pegel des empfangenen Signals über eine Zeitperiode umfasst, wobei der Verstärkungsgrad jedes Mal dann eingestellt wird, wenn der Parameter anzeigt, dass die Amplitude außerhalb eines Amplituden-Bereichs liegt, der zwischen einem oberen und einem unteren Amplituden-Schwellenwert definiert wird.

2. Verfahren nach Anspruch 1, bei dem die Einstellung des Verstärkungsgrades die Einstellung des Logarithmus des Verstärkungsgrades umfasst.

3. Verfahren nach Anspruch 2, bei dem die Einstellung des Logarithmus des Verstärkungsgrades die Inkrementierung oder Dekrementierung des Logarithmus des Verstärkungsgrades um einen vorgegebenen Betrag umfasst.

4. Verfahren gemäß einem der Ansprüche 1 bis 3, bei dem die Einstellung des Verstärkungsgrades eine Reduzierung des Verstärkungsgrades umfasst, wenn die Amplitude den oberen Schwellenwert überschreitet, und eine Erhöhung des Verstärkungsgrades, wenn die Amplitude unterhalb des unteren Schwellenwertes fällt.

5. Verfahren zum Modulieren eines empfangenen Signals, mit dem Anwenden eines Verstärkungsgrades bei dem empfangenen Signal und Einstellen des Verstärkungsgrades unter Verwendung des Verfahrens gemäß einem der vorhergehenden Ansprüche.

6. Vorrichtung zur Regelung des Verstärkungsgrades für ein empfangenes Signal (S1) mit Mitteln (16) zur Bestimmung eines Parameters, der die Differenz zwischen einem maximalen und einem minimalen Pegel des empfangenen Signals über einen Zeitraum einschließt, mit Mitteln (18) zur Einstellung des Verstärkungsgrades, jedes Mal dann, wenn der Parameter anzeigt, dass die Amplitude außerhalb eines Amplitudenbereichs liegt, der definiert wird zwischen einem oberen und einem unteren Amplituden-Schwellenwert.

7. Vorrichtung gemäß Anspruch 6, bei der die Einstellmittel (18) Mittel zur Einstellung des Logarithmus des Verstärkungsgrades umfassen.

8. Vorrichtung nach Anspruch 7, bei der die Mittel zur Einstellung des Logarithmus des Verstärkungsgrades so ausgebildet sind. dass sie den Logarithmus des Verstärkungsgrades um einen vorgegebenen Betrag inkrementieren oder dekrementieren.

9. Vorrichtung nach einem der Ansprüche 6 bis 8, bei dem die Einstellmittel Mittel zur Verringerung des Verstärkungsgrades, wenn die Amplitude den oberen Schwellenwert überschreitet, und zur Erhöhung des Verstärkungsgrades, wenn die Amplitude unter den unteren Schwellenwert fällt, umfassen.

10. Vorrichtung zur Modulierung eines empfangenen Signals mit Mitteln zum Anwenden eines Verstärkungsgrades auf das empfangene Signal und Vorrichtung gemäß einem der Ansprüche 6 bis 8 zur Variierung des Verstärkungsgrades.

11. Programm zur Durchführung des Verfahrens gemäß einem der Ansprüche 1 bis 5.

## Revendications

1. Procédé de contrôle du gain appliqué à un signal reçu, comprenant la détermination d'un paramètre comprenant la différence entre les niveaux maximal et minimal du signal reçu pendant une période donnée et le réglage du gain chaque fois que le paramètre indique que l'amplitude est en dehors d'une plage d'amplitude délimitée par des seuils d'amplitude supérieur et inférieur.

2. Procédé selon la revendication 1, dans lequel le réglage du gain comprend le réglage du logarithme du gain.

3. Procédé selon la revendication 2, dans lequel le réglage du logarithme du gain comprend une augmentation ou une diminution du logarithme du gain d'une quantité prédéterminée.

4. Procédé selon l'une quelconque des revendications 1 à 3, dans lequel le réglage du gain comprend la réduction du gain si l'amplitude dépasse le seuil supérieur et l'augmentation du gain si l'amplitude tombe en dessous du seuil inférieur.

5. Procédé de modulation d'un signal reçu, comprenant l'application d'un gain au signal reçu et le réglage du gain au moyen du procédé selon l'une quelconque des revendications précédentes.

6. Appareil pour contrôler le gain appliqué à un signal reçu (S1), comprenant des moyens (16) pour déterminer un paramètre comprenant la différence entre les niveaux maximal et minimal du signal reçu pendant une période donnée et des moyens (18) pour régler le gain chaque fois que le paramètre indique que l'amplitude est en dehors d'une plage d'amplitude délimitée par des seuils d'amplitude supérieur et inférieur.

7. Appareil selon la revendication 6, dans lequel les moyens de réglage (18) comprennent des moyens pour régler le logarithme du gain.

8. Appareil selon la revendication 7, dans lequel les moyens pour régler le logarithme du gain sont prévus pour augmenter ou diminuer le logarithme du gain d'une quantité prédéterminée.

9. Appareil selon l'une quelconque des revendications 6 à 8, dans lequel les moyens de réglage comprennent des moyens pour diminuer le gain si l'amplitude dépasse le seuil supérieur et pour augmenter le gain si l'amplitude tombe en dessous du seuil inférieur.

10. Appareil pour moduler un signal reçu, comprenant des moyens pour appliquer un gain au signal reçu et un appareil selon l'une quelconque des revendications 6 à 9 pour faire varier le gain.

11. Programme pour exécuter le procédé selon l'une quelconque des revendications 1 à 5.
